# EUROPÄISCHE PATENTSCHRIFT

(11) **EP 2 483 945 B1**
(45) Veröffentlichungstag und Bekanntmachung des Hinweises auf die Patenterteilung: **02.11.2016**
(21) Anmeldenummer: 10759683.5
(22) Anmeldetag: 30.09.2010
(51) Int. Cl.: H01L 51/54

(54) **ORGANISCHE ELEKTRONISCHE VORRICHTUNG UND VERFAHREN ZU DEREN HERSTELLUNG**
ORGANIC ELECTRONIC DEVICE AND METHOD FOR THE PRODUCTION THEREOF
DISPOSITIF ÉLECTRONIQUE ORGANIQUE ET PROCÉDÉ DE FABRICATION ASSOCIÉ

(30) Priorität: 30.09.2009 DE 102009047880
(43) Veröffentlichungstag der Anmeldung: 08.08.2012
(73) Patentinhaber: OSRAM OLED GmbH, 93049 Regensburg (DE)
(72) Erfinder: SCHMID, Günter, 91334 Hemhofen (DE); WEMKEN, Jan Hauke, 90459 Nürnberg (DE); KANITZ, Andreas, 91315 Höchstadt (DE)
(74) Vertreter: Epping - Hermann - Fischer
(86) Internationale Anmeldenummer: PCT/EP2010/064592
(87) Internationale Veröffentlichungsnummer: WO 2011/039323

(56) Entgegenhaltungen:
- WO-A1-2008/058929
- WO-A1-2009/122958
- JP-A- 2004 335 137
- US-A1- 2004 126 619
- GASSMANN ANDREA ET AL: "The Li3PO4/Al bilayer: An efficient cathode for organic light emitting devices", JOURNAL OF APPLIED PHYSICS, AMERICAN INSTITUTE OF PHYSICS, vol. 105, no. 8, 24 April 2009 (2009-04-24), pages 84513-1-84513-6, XP012125035, ISSN: 0021-8979, DOI: 10.1063/1.3112005

## Beschreibung

Die vorliegende Erfindung betrifft organische elektronische Bauelemente, wie beispielsweise organische Licht emittierende Vorrichtungen, organische photosensitive Vorrichtungen, wie beispielsweise photovoltaische Zellen oder Photodetektoren oder organische Transistoren, zum Beispiel organische Feldeffekttransistoren.

Ein weit verbreitetes Problem bei organisch elektronischen Vorrichtungen ist im Falle von elektrolumineszenten Vorrichtungen beispielsweise die Gewährleistung einer ausreichenden Ladungsträgerinjektion über die Anode und Kathode zu der zumindest einen organisch elektrolumineszierenden Schicht. Bei einer OLED werden durch die Rekombination von injizierten Elektronen und Löchern Exzitonen gebildet, die die organische elektrolumineszierende Schicht zur Lumineszenz anregen. Dabei hängen sowohl die Luminanz, die Effizienz als auch die Lebensdauer der OLEDs stark von den durch Ladungsträgerinjektion in der elektrolumineszierenden Schicht gebildeten Exzitonendichte und auch von der Qualität der Ladungsträgerinjektion ab.

Analog zu organischen Licht emittierenden Dioden (OLEDs) treten auch bei organischen photosensitiven Vorrichtungen, beispielsweise photovoltaischen Zellen oder Photodetektoren, Probleme beim Ladungsträgertransport der in der photoaktiven Schicht mittels Excitonentrennung gebildeten Elektronen und Löchern zu den Elektroden hin auf. Der Ladungsträgertransport spielt auch bei organisch elektronischen Vorrichtungen, die keine Anwendung in der Optoelektronik haben, beispielsweise bei organischen Transistoren, wie organischen Feldeffekttransistoren eine große Rolle und bestimmt die elektrischen Eigenschaften mit.

In der Veröffentlichung "Elucidation of the electron injection mechanism of evaporated caesium carbonate cathode interlayer for organic light emitting diodes" in dem Journal Applied Physics Letters (90, 2007) werden Elektroneninjektionsschichten in OLEDs beschrieben, die durch Vakuumabscheidung von Cäsiumcarbonat gebildet werden und eine erhöhte Effizienz der OLED-Vorrichtung bedingen. Die Autoren dieser Veröffentlichung kommen dabei zum Schluss, dass bei der Vakuumabscheidung Cäsiumcarbonat zu metallischem Cäsium zerfällt, das eine dünne Schicht bildet, die dann als Elektroneninjektionsschicht dient. Andere Autoren diskutieren eine Zersetzung des Cäsiumcarbonats zu Cs₂O und CO₂. Dies hat zur Folge, dass das Anion des zur Vakuumabscheidung eingesetzten Salzes, also Carbonat keine Rolle bei der Elektroneninjektion spielen sollte.

JP2004335137 beschreibt eine OLED mit einer dotierten Elektroneninjektionsschicht. Hierbei werden Cäsium- und Rubidiumsalze als Dotanden verwendet. A. Grassmann et al., J. Appl. Phys. 105, 084513 (2009) beschreiben eine OLED mit einer Li₃PO₄dotierten Alq₃-Schicht.

Eine Aufgabe von Ausführungsformen der Erfindung besteht darin, eine organische, elektronische Vorrichtung anzugeben, bei der der Elektronentransport verbessert ist.

Diese Aufgabe wird gelöst durch eine organische elektronische Vorrichtung gemäß Anspruch 1. Weitere Patentansprüche sind auf bevorzugte Ausführungsbeispiele der organischen elektronischen Vorrichtung und Verfahren zu deren Herstellung gerichtet.

Eine Ausführungsform der Erfindung umfasst eine organisch elektronische Vorrichtung mit
- einem Substrat,
- einer ersten Elektrode,
- einer zweiten Elektrode, und
- einem zwischen der ersten und zweiten Elektrode angeordneten elektronenleitenden Bereich, der
- ein organisches Matrixmaterial und ein Salz aufweist, wobei das Salz
- ein Metallkation und
- ein Anion mit zumindest dreifacher Wertigkeit umfasst.

Im Gegensatz zu der bereits oben in der Beschreibungseinleitung genannten Veröffentlichung haben die Erfinder festgestellt, dass die Beschaffenheit des Anions eines Metallsalzes eine Rolle beim Ladungsträgertransport in einer organischen elektronischen Vorrichtung spielt. Die Erfinder gehen dabei davon aus, dass das Anion des Metallsalzes das zur Herstellung der organisch elektronischen Vorrichtung verwendet wird, in diese Vorrichtung eingebaut wird und die Wertigkeit, also die Ladung der Anionen eine Rolle bei dem Elektronentransport spielt. Dabei kann im Vergleich zu dem im Stand der Technik verwendeten Cäsiumcarbonats, das nur eine Wertigkeit von 2, also eine zweifach negative Ladung aufweist, bei einem Anion mit zumindest dreifacher Wertigkeit (dreifach negativer Ladung) eine Verbesserung der elektrischen Eigenschaften der organischen elektronischen Vorrichtung beobachtet werden.

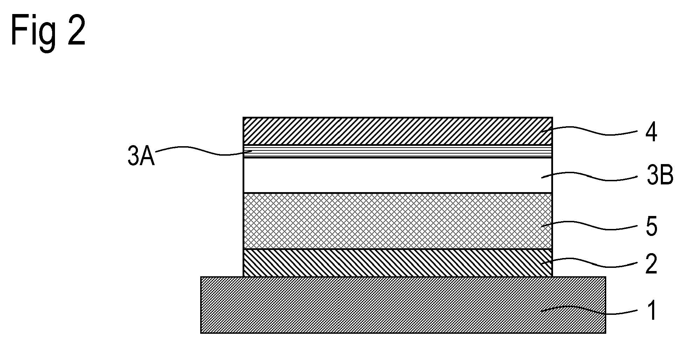

In einer Ausführungsform einer erfindungsgemäßen organischen elektronischen Vorrichtung weist der Elektronen leitende Bereich zumindest zwei Schichten auf, von der eine erste Schicht das Matrixmaterial umfasst und eine zweite zur ersten Schicht in Kontakt stehende Schicht das Salz umfasst, wobei diese zweite Schicht als so genannte Elektroneninjektionsschicht bevorzugt näher an der Elektrode angeordnet ist, die als Kathode geschaltet ist als die erste Schicht, die das Matrixmaterial umfasst (siehe beispielsweise Figur 2).

In einer anderen bevorzugten Ausführungsform der Erfindung kann der Elektronen leitende Bereich eine elektronenleitende Schicht aufweisen, die das organische Matrixmaterial enthält in das das Salz als n-Dotierstoff eingebracht ist. Bei dieser Ausführungsform sind die Verbesserungen der elektrischen Eigenschaften besonders ausgeprägt.

Verwendet werden kann die elektronenleitende Schicht, die das organische Matrixmaterial enthält in das das Salz als n-Dotierstoff eingebracht ist beispielsweise als eine Ladungsträgertransport-Schicht, die Elektroden von einem Teilbereich zu einem anderen Teilbereich einer organischen elektronischen Vorrichtung transportiert. Weiterhin kann die elektronenleitende Schicht auch Bestandteil eines sogenannten Ladungsträger generierenden Bereichs sein, ein sog. "charge generation layer (CGL)", bei dem zum Beispiel eine dotierte Lochtransportschicht und eine dotierte Elektronentransportschicht vorliegen, die durch eine dünne Zwischenschicht aus z. B. Metall getrennt sein können oder auch direkt in Kontakt miteinander stehen. Eine derartige CGL kann zum Beispiel verschiedene OLED-Subzellen in einer OLED-Tandemzelle miteinander verbinden.

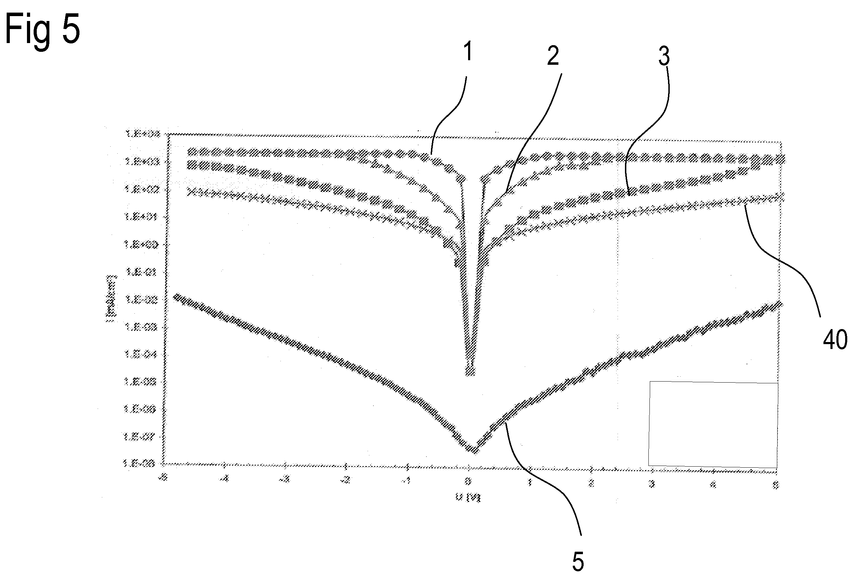

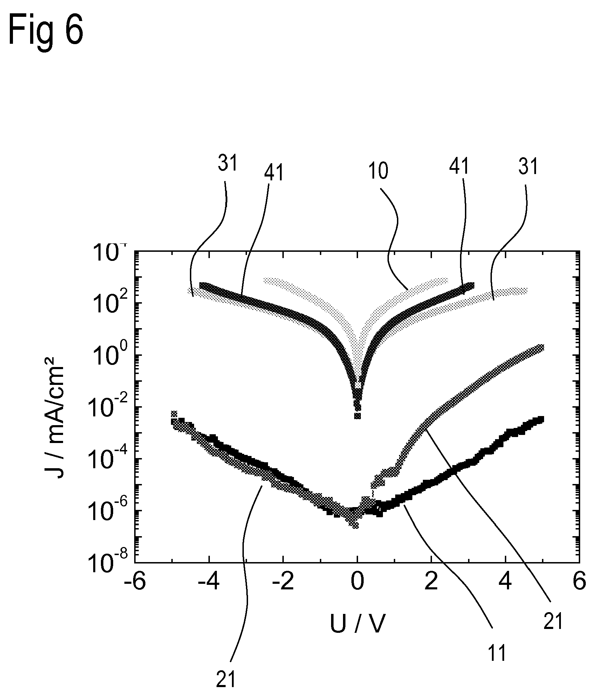

Die Erfinder haben festgestellt, dass Salze mit zumindest dreiwertigen Anionen, also zum Beispiel drei- oder vierwertige Anionen als Dotierstoffe in Schichten mit Matrixmaterialien gegenüber Dotierstoffen aus Salzen mit lediglich zweiwertigen Anionen, wie beispielsweise Cäsiumcarbonat, Vorteile aufweisen. So ist es beispielsweise möglich, Salze mit zumindest dreiwertigen Anionen als Dotierstoff in Elektronen transportierenden Matrixmaterialien in bis zu fünffach geringeren Konzentrationen einzusetzen als Salze mit zweiwertigen Anionen. Weiterhin zeigen Stromspannungskennlinien, dass die Verbesserung der Leitfähigkeit bei Dotierung mit Salzen mit zumindest dreiwertigen Anionen um wenigstens eine Größenordnung besser ist, als bei Salzen, die lediglich zweiwertige Anionen aufweisen (siehe beispielsweise ein Vergleich der Figuren 5 und 6). Aufgrund der niedrigeren Dotierstoffkonzentration bei Salzen mit zumindest dreiwertigen Anionen resultiert auch häufiger ein verbesserter Farbeindruck der elektronischen Vorrichtungen im ausgeschalteten Zustand im Vergleich zu Salzen mit zweiwertigen Anionen. Beispielsweise führt eine Dotierung des Matrixmaterials BCP mit Cäsiumcarbonat zu einem bläulichen Farbeindruck der dotierten Elektronentransportschicht im ausgeschalteten Zustand, während eine Dotierung mit beispielsweise Cäsiumphosphat als ein Beispiel für ein Salz mit einem zumindest dreiwertigen Anion im ausgeschalteten Zustand der organischen elektronischen Vorrichtung einen neutraleren Farbeindruck hinterlässt.

Im Falle, dass das Salz als n-Dotierstoff in die Schicht, die das Matrixmaterial beinhaltet, eingebracht ist, ist es vorteilhaft, wenn der n-Dotierstoff in einer Konzentration von 1 bis 50 Vol%, bevorzugt 5 bis 15 Vol-% in dem organischen Matrixmaterial vorliegt. Vol-%-Konzentrationen in diesem Bereich führen dabei zu einer besonders ausgeprägten Verbesserung der elektrischen Eigenschaften, zum Beispiel der Strom-Spannungskennlinien. Dies ist bei Verwendung von BCP als Matrixmaterial besonders ausgeprägt.

Das Metallkation des Salzes kann ausgewählt sein aus:
- einwertigen Metallkationen,
- Erdalkalimetallkationen,
- Zirkoniumkationen oder Kombinationen davon.

Die Erfinder haben festgestellt, dass vor allen Dingen einwertige Metallkationen, wie zum Beispiel Alkalimetallkationen wir Rb(I) und Cs(I), oder Ag(I), Cu(I), Tl(I) und Erdalkalimetallkationen in Kombination mit zumindest dreiwertigen Anionen gute Dotierstoffe sind. Diese Salze von dreiwertigen Anionen sind auch unzersetzt verdampfbar.

Das Anion mit zumindest dreifacher Wertigkeit ist ausgewählt aus:
- Phosphatanionen PO₄³⁻,
- anionischen multivalenten organischen Anionen mit zumindest dreifacher Wertigkeit, wie beispielsweise das Trianion der 1,3,5-Benzoltricarbonsäure oder das Tetraanion der Naphtalintetracarbonsäure oder zumindest dreiwertige organische Säuren, wie zum Beispiel das Tetraanion der Methantetracarbonsäure oder das Trianion der Methantricarbonsäure.

Die entsprechenden Cäsiumsalze der Methantetracarbonsäure und der Methantricarbonsäure haben folgende Strukturen:

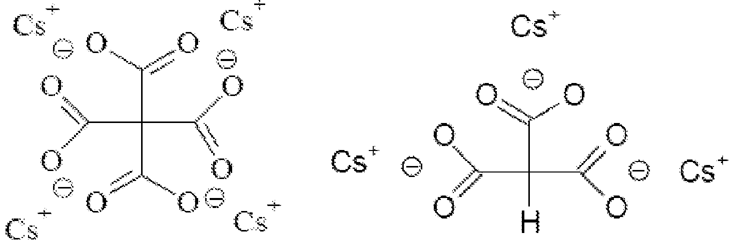

Die organischen Anionen können dabei beispielsweise auch aromatische Ringe mit Stickstoffatomen aufweisen. Alle oben genannten Anionen und Kationen können auch in Kombination verwendet werden.

Die Erfinder haben gefunden, dass die oben genannten Kationen und Anionen, vor allen Dingen Phosphat positive Auswirkungen auf die elektrischen Eigenschaften einer organischen elektronischen Vorrichtung haben, wenn sie als Dotierstoff in Elektronentransportierenden Schichten verwendet werden.

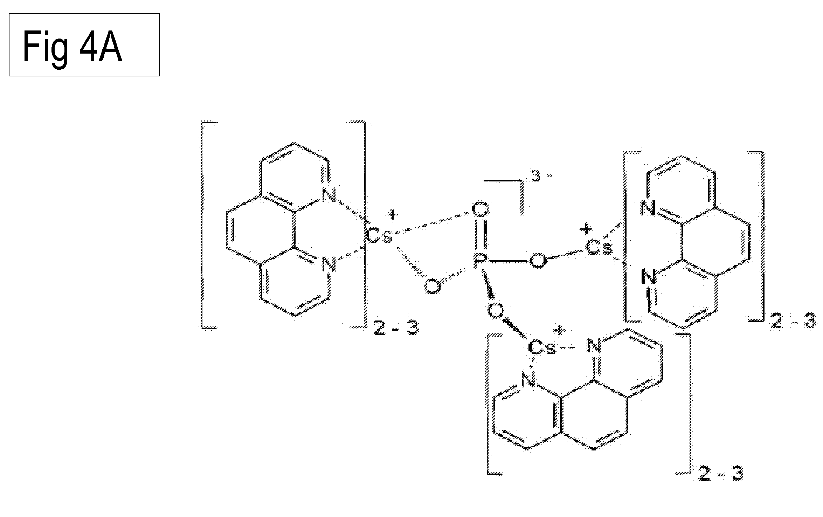

Für dem Fall, dass das Salz als n-Dotierstoff in einer Schicht, die das organische Matrixmaterial umfasst, verwendet wird, kann das undissoziierte Salz beispielsweise über das Metallkation an das organische Matrixmaterial koordiniert sein (siehe beispielsweise Figur 4A). In Abhängigkeit von ihrer Wertigkeit können die Anionen als Chelat-Liganden wirken, wobei beispielsweise ein dreiwertiges Anion wie das Phosphatanion dreizähnig sein kann und somit drei Metallkationen als Koordinationspartner aufweisen kann, im Falle von Cäsiumphosphat beispielsweise Cs(I).

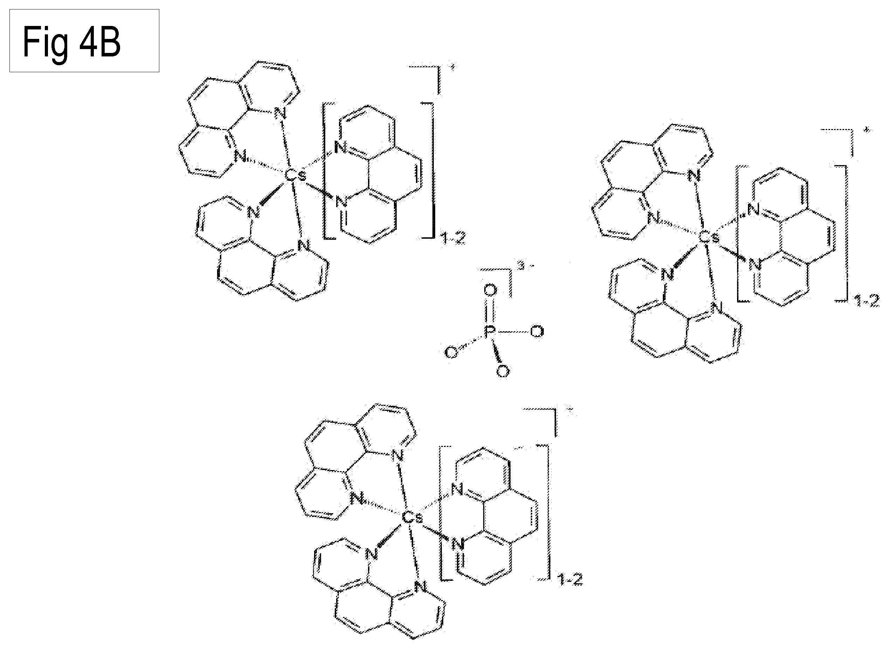

Weiterhin ist es denkbar, dass der Dotierstoff, beispielsweise bei einer Koevaporation (Ko-Verdampfung) des Matrixmaterials und des Salzes, unter Dissoziation des Salzes eine Koordinationsverbindung zwischen dem Metallkation des Salzes und dem organischen Matrixmaterial als Ligand bildet, wobei in diese Matrix dann das Anion eingelagert ist (siehe beispielsweise Figur 4B). Besonders vorteilhaft kann sich im Falle einer Komplexbildung zwischen dem Kation des Salzes und dem organischen Matrixmaterial als Ligand ein dreidimensionales leitfähiges Netzwerk über koordinative Bindungen ausbilden.

In einer weiteren Ausführungsform einer erfindungsgemäßen organischen elektronischen Vorrichtung umfasst das organische Matrixmaterial eine stickstoffhaltige heterozyklische Verbindung. Dabei kann es sich beispielsweise um Pyridin-Grundstrukturen handeln, wie beispielsweise 2,9-Dimethyl-4,7-diphenyl-1,10-phenanthrolin (BCP). Stickstoffhaltige heterozyklische Verbindungen sind besonders gut geeignet, um als Liganden für die Metallkationen des n-Dotierstoffsalzes zu dienen und sind im Allgemeinen auch gute Elektronenleiter.

In einer weiteren Ausführungsform der Erfindung umfasst das organische Matrixmaterial eine Wiederholeinheit mit folgender allgemeiner Formel: 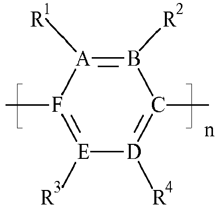 hierbei
- stehen die Ringglieder A bis F unabhängig voneinander für C oder N mit der Maßgabe dass maximal zwei N-Atome vorhanden sein können,
- n ist eine ganze Zahl zwischen 2 bis 8, wobei die freien Valenzen der Enden der Ketten der Wiederholeinheiten jeweils unabhängig voneinander durch H, Methyl, Phenyl, 2-Pyridyl, 3-Pyridyl bzw. 4-Pyridyl abgesättigt sein können,
R¹ bis R⁴ können jeweils unabhängig voneinander H, Methyl, Phenyl, 2-Pyridyl, 3-Pyridyl bzw. 4-Pyridyl sein und / oder R¹ und R² bzw R³ und R⁴ können miteinander Butadien bzw. Azabutadieneinheiten bilden, so dass ein anneliertes 6-Ring System gebildet wird und die Wiederholeinheiten können zwischen dem n-ten und (n+1)-ten Ring durch Ethylen- bzw. Azomethineinheiten verbunden sein, wobei Phenanthren- bzw. Azaphenanthreneinheiten gebildet werden.

Derartige Oligo-pyridyl und/oder Oligo-pyrinidyl-Arene sind besonders geeignet, da sie gut an die Dotierstoffe koordinieren und sind beispielsweise in der PCT-Patentanmeldung WO2008/058929 offenbart auf die im Hinblick auf diese Materialen Bezug genommen wird. Die Ladungsträgertransporteigenschaften der genannten Matrixmaterialien lässt sich dabei über die Anzahl der Stickstoffatome im Ringsystem steuern.

Das organische Matrixmaterial kann dabei aus den folgenden konkreten Verbindungen und deren Kombinationen ausgewählt sein:

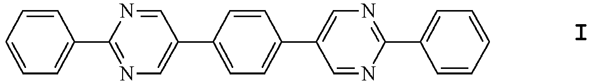

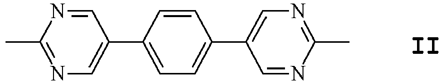

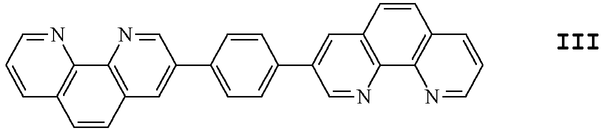

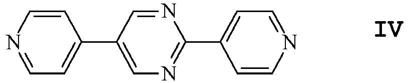

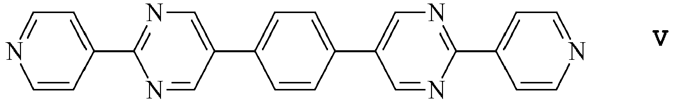

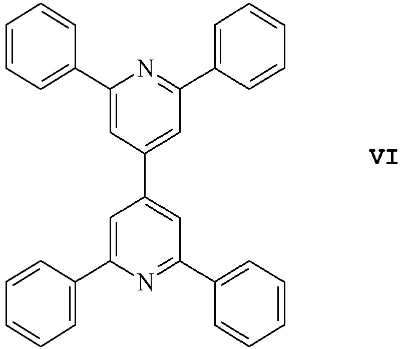

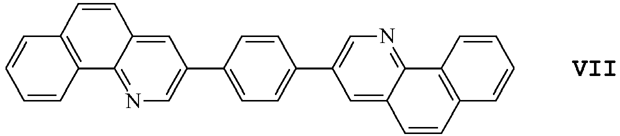

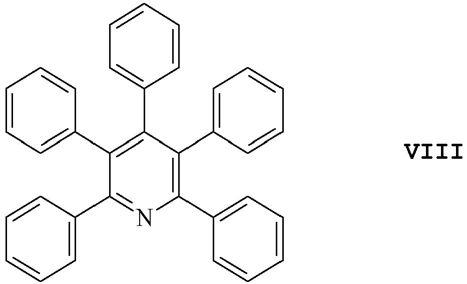

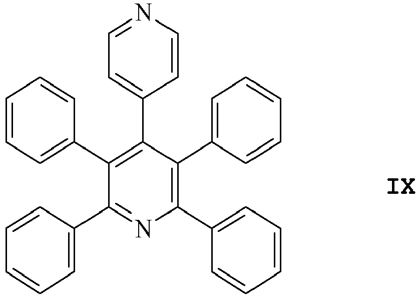

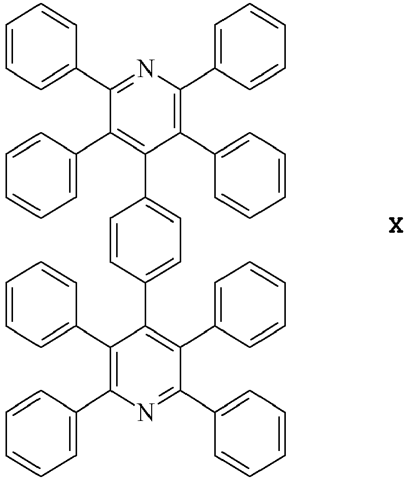

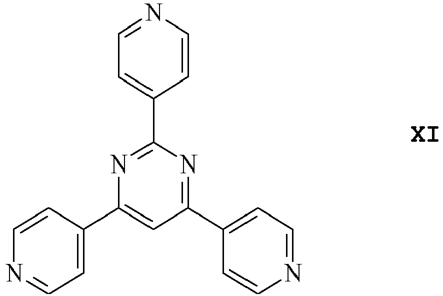

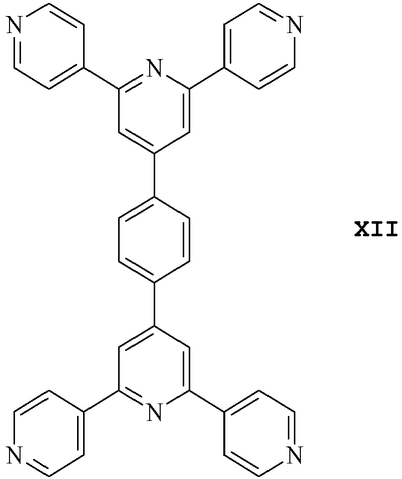

Weitere Möglichkeiten sind auch folgende Matrixmaterialien, sowie deren Kombinationen:
- 2,2',2''-(1,3,5-Benzintriyl)-tris(1-phenyl-1-H-benzimidazol),
- 2-(4-Biphenylyl)-5-(4-tert.-butylphenyl)-1,3,4-oxadiazol,
- 2,9-Dimethyl-4,7-diphenyl-1,10-phenanthrolin (BCP),
- 4-(Naphthalen-1-yl)-3,5diphenyl-4H-1,2,4-triazol,
- 1,3-Bis[2-(2,2'-bipyridin-6-yl)-1,3,4-oxadiazo-5-yl]benzol,
- 4,7-Diphenyl-1,10-phenanthrolin,
- 3-(4-Biphenylyl)-4-phenyl-5-tert-butylphenyl-1,2,4-triazol,
- 6,6'-Bis[5-biphenyl-4-yl)-1,3,4-oxadiazo-2-yl]2,2'bipyridyl,
- 2-phenyl-9,10-di(naphthalen-2-yl)-anthracen,
- 2,7-Bis[2-(2,2'-bipyridin-6-yl)1,3,4oxadiazo-5-yl]-9,9-dimethylfluoren,
- 1,3-Bis[2-(4-tert.-butylphenyl)-1,3,4-oxadiazo-5-yl)benzol,
- 2-(naphthalen-2-yl)-4,7-diphenyl-1,10-phenanthrolin,
- 2,9-Bis(naphthalen-2-yl)-4,7-diphenyl-1,10-phenanthrolin,
- Tris(2,4,6-trimethyl-3-(pyridine-3yl)phenyl)boran,
- 1-methyl-2-(4-(naphthalene-2-yl)phenyl)1-H-imidazo[4,5-f][1,10]-phenanthrolin,
- Silole mit Silacyclopentadien-Einheiten.

Als Salze für Dotierstoffe sind besonders Alkalisalze der Phosphate, beispielsweise Cäsiumphosphat bevorzugt.

Gegenstand einer weiteren Ausführungsform der Erfindung ist eine als organische Elektrolumineszenz-Diode (OLED) ausgebildete organische elektronische Vorrichtung, die weiterhin eine organische elektrolumineszierende Schicht zwischen dem elektronenleitenden Bereich und einer der Elektroden umfasst. Dabei ist die elektrolumineszierende (EL)-Schicht im Schichtstapel der OLED-Vorrichtung so angeordnet, dass sich der elektronenleitende Bereich zwischen der EL-Schicht und der als Kathode geschalteten Elektrode, befindet. Bei einer derartigen Ausgestaltung einer OLED ist ein besonders guter Elektronentransport von der Kathode zur organischen EL-Schicht gewährleistet.

Weiterhin kann die organische elektronische Vorrichtung der vorliegenden Erfindung auch als organische photosensitive Vorrichtung ausgebildet sein, wobei eine organische photoaktive Schicht, beispielsweise ein Volumenheteroübergang (bulk heterojunction) zwischen einem n- und einem p-leitenden Material vorhanden ist. Das n-leitende Material kann beispielsweise Fulleren C₆₀ sein, das beispielsweise mit p-leitenden Polymeren wie Polyparaphenylenvinylen gemischt ist oder in separaten übereinander aufgebrachten Schichten ausgeformt ist. Bei einer derartigen organischen photosensitiven Vorrichtung ist dann ebenfalls der erfindungsgemäße elektronenleitende Bereich zwischen der organischen photoaktiven Schicht und der als Kathode geschalteten Elektrode angeordnet und ermöglicht so einen besonders effizienten Abtransport der durch Lichteinstrahlung aus Excitonen gebildeten Elektronen aus der organischen photoaktiven Schicht.

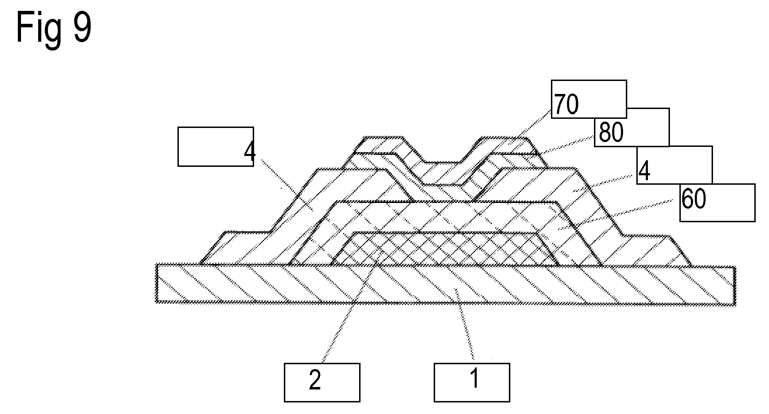

Ein weiteres Beispiel für eine organische elektronische Vorrichtung ist ein organischer Transistor, beispielsweise ein Feldeffekttransistor, bei dem ein organischer Halbleiter, der beispielsweise die erfindungsgemäße elektronenleitende Schicht mit dem Salz als Dotierstoff umfassen kann, vorhanden sein kann (siehe z.B. Fig. 9). Eine derartige elektronenleitende Schicht kann zum Beispiel in Kontakt mit den Elektroden des Transistors stehen, um eine Verbesserung der Injektion von Ladungsträgern zu erreichen. Besonders bevorzugt wird die elektronenleitende Schicht in n-Kanaltransistoren verwendet.

Gegenstand der Erfindung ist weiterhin ein Verfahren zur Herstellung einer organischen elektronischen Vorrichtung gemäß Anspruch 1 mit den Verfahrensschritten:
A) Bereitstellen eines Substrats mit einer ersten Elektrode,
B) Aufbringen einer Elektronen leitenden Schicht auf der ersten Elektrode,
C) Aufbringen einer zweiten Elektrode, die im elektrisch leitenden Kontakt mit der Elektronen leitenden Schicht steht,
   - wobei das Aufbringen der Elektronen leitenden Schicht durch Verdampfen des organischen Matrixmaterials und des Salzes erfolgt.

Besonders bevorzugt wird im Verfahrensschritt B) der elektronenleitende Bereich mittels Gasphasenabscheidung, besonders bevorzugt mittels physikalischer Gasphasenabscheidung (PVD) erzeugt. Für den Fall, dass der elektronenleitende Bereich eine Schicht eines organischen Matrixmaterials mit dem Salz als n-Dotierstoff darstellt, ist eine Ko-Evaporation oder Ko-Verdampfung des Salzes und des organischen Matrixmaterials bevorzugt. Die Salze mit dem zumindest dreiwertigen Anion sind gut verdampfbar, wobei häufig nur geringe oder gar keine Rückstände zu beobachten sind. Aufgrund der hohen zumindest dreifach negativ vorhandenen Ladung des Anions sollten derartige Salze schwer verdampfbar sein. Die Erfinder haben aber festgestellt, dass überraschenderweise beispielsweise das Salz Cäsiumphosphat aus strombeheizten Molybdänbooten praktisch rückstandsfrei verdampfbar ist. Die Verdampfungseigenschaften von Cäsiumphosphat sind dabei denen des Salzes Lithiumfluorid ähnlich, das allerdings nur ein einfach negativ geladenes Fluoridanion aufweist. Das aus dem Stand der Technik bekannte Cäsiumcarbonat bildet im Gegensatz dazu unter gleichen Bedingungen nicht verdampfbare Rückstände.

Gegenstand der Erfindung ist auch eine elektronenleitende Zusammensetzung, umfassend:
- eine elektronenleitendes Matrixmaterial, das die bereits weiter oben genannten Verbindungen umfasst, und
- ein Salz als n-Dotierstoff, wobei das Salz
- ein Anion mit zumindest dreifacher Wertigkeit und
- ein Kation aufweist, wobei das Anion ausgewählt ist aus: Phosphationen PO₄³⁻ und anionischen multivalenten organischen Anionen.

Im Folgenden sollen Aspekte der vorliegenden Erfindung anhand von Ausführungsbeispielen und Figuren näher erläutert werden.
- Figur 1: zeigt im schematischen Querschnitt eine Ausführungsform einer erfindungsgemäßen organischen elektronischen Vorrichtung, die entweder als organische photosensitive Vorrichtung oder als organische elektrolumineszierende Vorrichtung (OLED) ausgebildet sein kann, wobei das Salz als n-Dotierstoff in eine Matrix des organischen Matrixmaterials eingebracht ist.
- Figur 2: stellt einen schematischen Querschnitt einer weiteren Ausführungsform einer erfindungsgemäßen organischen elektronischen Vorrichtung dar, bei der das organische Matrixmaterial und das Salz in separaten Schichten angeordnet sind.
- Figuren 3A und 3B: zeigen in perspektivischer Ansicht und in Querschnittsansicht im größeren Detail eine organische elektrolumineszierende Vorrichtung gemäß dieser Erfindung.
- Die Figuren 4A und 4B: zeigen unterschiedliche Koordinationsmöglichkeiten zwischen dem Salz mit dem zumindest dreiwertigen Anion und dem organischen Matrixmaterial für den Fall dass das Salz als n-Dotierstoff in das organische Matrixmaterial eingebracht ist.
- Figur 5: zeigt die Stromspannungskennlinien einer erfindungsgemäßen OLED-Vorrichtung mit unterschiedlichen Dotierstoffkonzentrationen an Cäsiumphosphat in BCP als Matrixmaterial.
- In der Figur 6: sind im Vergleich dazu die Stromspannungskennlinien von OLED-Vorrichtungen gezeigt, bei denen das aus dem Stand der Technik bekannte Dotierstoffmittel Cäsiumcarbonat in unterschiedlichen Konzentrationen verwendet wurde.
- Figur 7: zeigt zwei verschiedene Stromspannungskennlinien zu Beginn und nach 66 Stunden Belastung mit 1 mA Strom für eine BCP-Matrix mit 15 Vol% Cs₃PO₄.
- Figur 8: zeigt die chemischen Strukturen von möglichen Ladungsträgertransportmaterialien und elektrolumineszierenden Materialien, die in erfindungsgemäßen OLED-Vorrichtungen verwendet werden können.
- Figur 9: zeigt im schematischen Querschnitt einen organischen Feldeffekttransistor gemäß der Erfindung.
- Figur 10: zeigt die Stromspannungskennlinien einer zwischen zwei Elektroden angeordneten elektronenleitenden Schicht mit unterschiedlichen Dotierstoffkonzentrationen an dem Cäsiumsalz der Methantetracarbonsäure (Cs₄C₅O₈) in BCP und anderen Matrixmaterialien.

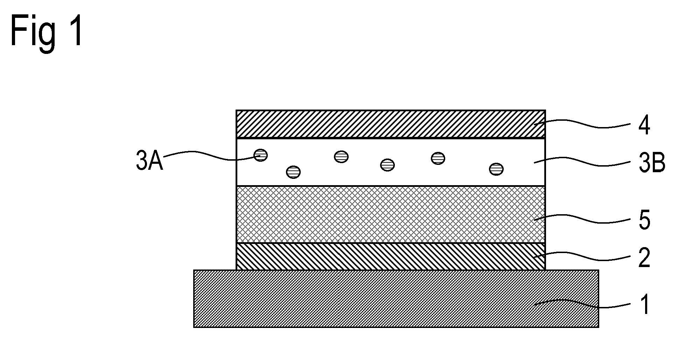

Figur 1 zeigt im Querschnitt eine organische elektronische Vorrichtung mit einem Substrat 1, einer ersten Elektrode 2 und einer zweiten Elektrode mit dem Bezugszeichen 4 und einer organischen funktionellen Schicht 5, die im Falle einer OLED eine organische elektrolumineszierende (EL)-Schicht umfasst, oder im Falle einer organischen photosensitiven Vorrichtung eine photoaktive Schicht beinhaltet. Zwischen der organischen funktionellen Schicht 5 und der zweiten Elektrode 4, die als Kathode geschaltet ist, befindet sich ein elektronenleitender Bereich, der ein organisches Matrixmaterial 3B sowie ein Salz 3A mit einem zumindest dreiwertigen Anion umfasst, das als n-Dotierstoff in die Schicht 3B des organischen Matrixmaterials eingebracht ist. Eine derartige organische elektronische Vorrichtung weist aufgrund des elektronenleitenden Bereichs 3A und 3B eine verbesserte Ladungstransportfähigkeit für Elektronen zwischen der Kathode 4 und der organischen funktionellen Schicht 5 auf. Im Falle einer OLED ist bei einer derartigen Vorrichtung der Elektronentransport von der Kathode 4 zur organischen elektrolumineszierenden Schicht 5 hin verbessert, während im Falle einer organischen photoaktiven Schicht der Abtransport von in der photoaktiven Schicht 5 gebildeten Elektronen hin zur Kathode 4 verbessert ist.

Die in Figur 2 dargestellte schematische Querzeichnung zeigt eine zu Figur 1 alternative Ausführungsform der organisch elektronischen Vorrichtung. Im Gegensatz zur Figur 1 ist hier der Elektronen leitende Bereich als zwei separate Schichten ausgeführt, nämlich eine Schicht umfassend das Matrixmaterial 3b und eine davon separate Schicht 3a, die das Salz mit dem Anion mit zumindest dreifacher Wertigkeit umfasst. Ansonsten sind alle weiteren Schichten gegenüber der Darstellung in Figur 1 unverändert. Bei den in Figur 1 und Figur 2 gezeigten Vorrichtungen können zusätzliche Schichten vorhanden sein.

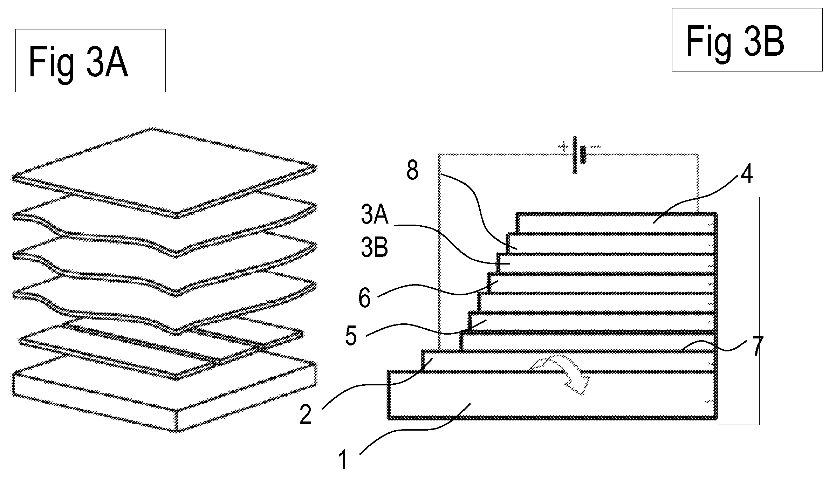

Die Figuren 3A und 3B zeigen dabei in perspektivischer Sicht und im Querschnitt eine weitere Ausführungsform einer erfindungsgemäßen OLED, bei der neben der organischen elektrolumineszierenden Schicht 5 und der erfindungsgemäßen elektronenleitenden Schicht 3A, 3B auch weitere Schichten, beispielsweise eine lochtransportierende Schicht 9, eine Lochinjektionsschicht 7, eine Lochblockierschicht 6 und eine Elektroneninjektionsschicht 8 vorhanden sind, die einen effektiven Ladungsträgertransport von der Anode 2 und der Kathode 4 zur elektrolumineszierenden Schicht gewährleisten.

Figur 4A zeigt eine Koordinationsmöglichkeit zwischen dem Salz mit dem zumindest dreiwertigen Anion und eines Matrixmaterials für den Fall, dass das Salz Cäsiumphosphat und das Matrixmaterial BCP (2,9-Dimethyl-4,7-diphenyl-1,10-phenanthrolin) darstellt, wobei aus Gründen der Übersichtlichkeit die Methyl- und Phenylsubstituenten von BCP nicht dargestellt sind. Figur 4A lässt sich entnehmen, dass das Salz Cäsiumphosphat nicht dissoziiert ist und in das organische Matrixmaterial einlagert ist, wobei das Salz über die Cäsiumkationen BCP als Ligand koordiniert. In diesem Fall wirkt das dreiwertige Phosphat Anion, das drei Cäsiumkationen bindet, als dreizähniger Chelat-Ligand. Jedes Cäsiumkation des Cäsiumphosphatsalzes kann dabei noch zwei bis drei BCP-Moleküle als Liganden koordinieren.

Figur 4B zeigt eine weitere Möglichkeit einer Koordinierung von Cäsiumphosphat als Salz mit BCP als organischem Matrixmaterial. Dabei liegt das Cäsiumphosphat in dissoziierter Form mit getrennten Anionen und Kationen vor und es bilden sich Koordinationsverbindungen zwischen dem Cäsiumkation und BCP, wobei aus Gründen der Neutralität das Phosphatanion zum Ladungsausgleich in die Matrix eingelagert ist.

Figur 5 zeigt die Veränderung der Stromspannungskennlinien von BCP-Schichten, die zwischen einer ITO-Anode und einer Aluminium-Kathode angeordnet sind bei Veränderungen der Dotierstoffkonzentration von Cäsiumphosphat als dotierendem n-Dotierstoff relativ zu BCP als Matrixmaterial. Die Schichtanordnungen wurden hergestellt, indem eine 200 nm dicke BCP-Schicht durch thermisches Verdampfen auf ein mit ITO (Indiumzinnoxid) strukturiertes Glasssubstrat abgeschieden wurde, wobei die Verdampfungsraten von Cäsiumphosphat relativ zur Verdampfungsrate des BCP 5%, 10%, 15% und 30% betrugen (Ko-Evaporation von BCP und Cäsiumphosphat). Auf die dotierte BCP-Schicht wurde als Kathode Aluminium gedampft. Die mit dem Bezugszeichen 50 gekennzeichnete Stromspannungskennlinie kennzeichnet dabei das I-U-Verhalten einer reinen undotierten BCP-Schicht, die zwischen der ITO-Anode und der Aluminiumkathode angeordnet ist. Die mit dem Bezugszeichen 30 versehene Stromspannungskennlinie kennzeichnet dabei die I-U-Charakteristik einer BCP-Schicht, die 5 Vol-% Cäsiumphosphat als n-Dotierstoff enthält. Demgegenüber verändert sich die Stromspannungskennlinie bei einer Erhöhung der Dotierstoffkonzentration auf 10 Vol-% gemäß der Stromspannungskennlinie 10 und bei einer Erhöhung auf 15 Vol-% gemäß der Stromspannungskennlinie 20. Zu beobachten ist, dass bei einer Dotierstoffkonzentration von 30 Vol-% die elektrischen Eigenschaften sich leicht verschlechtern (mit 40 gekennzeichnete Stromspannungskennlinie). Dabei ist zu beobachten, dass in einem Konzentrationsbereich von 5 Vol-% bis 15 Vol-% eine gute Verbesserung des Stromspannungsverhaltens gegenüber undotiertem BCP beobachtet werden kann, während sich bei 30 % dieses wieder verschlechtert.

Figur 6 zeigt die Stromspannungskennlinien einer zwischen einer ITO-Anodenschicht und einer Aluminiumkathodenschicht angeordneten BCP-Schicht, die mit unterschiedlichen Vol-% Konzentrationen von Cs₂CO₃ dotiert ist. Die mit 11 gekennzeichnete Stromspannungskennlinie stellt dabei das Stromspannungsverhalten einer reinen BCP-Schicht dar, während die mit 21 bezeichnete Linie eine Dotierung mit 1 Vol-% Cäsiumcarbonat kennzeichnet. Die mit 31 bezeichnete Stromspannungskennlinie wurde gemessen, wenn eine Dotierung mit 10 Vol-% Cäsiumcarbonat vorliegt und die Stromspannungskennlinie 41 wurde bei einer Dotierung mit 20 Vol-% Cäsiumcarbonat erhalten. Bei einer 1:1-Dotierung mit 50 Vol-% Cäsiumcarbonat wurde die mit 10 bezeichnete I-U-Charakteristik erhalten.

Ein Vergleich der Stromspannungskennlinien der Figuren 5 und 6 zeigt dabei deutlich, dass bei Verwendung von Cäsiumphosphat Cs₃PO₄ als Dotierstoff im Vergleich zu Cäsiumcarbonat Cs₂CO₃ deutliche Verbesserungen des elektrischen Verhaltens zu beobachten sind. Einerseits können vergleichbare Strom-Spannungs-Kurven bei einer fünffach geringeren Konzentration von Cäsiumphosphat im Vergleich zu Cäsiumcarbonat erzielt werden. Häufig resultiert bei Dotierung mit Cäsiumphosphat eine um einen Größenordnung 1 verbesserte Stromspannungskennlinie gegenüber Cäsiumcarbonat als Dotierstoff. Weiterhin sind die mit hohen Cäsiumcarbonat-Konzentrationen dotierten BCP-Schichten im ausgeschalteten Zustand blau gefärbt, während aufgrund der niedrigeren Dotierstoffkonzentrationen bei Cäsiumphosphat die dotierten BCP-Schichten einen neutraleren Farbeindruck hinterlassen. Dies ist besonders wichtig für den Farbeindruck von OLED-Vorrichtungen im ausgeschalteten Zustand, der möglichst farbneutral sein sollte. Die Figuren 5 und 6 zeigen somit deutlich, dass durch die Verwendung eines Dotierstoffsalzes mit einem dreiwertigen Anion im Vergleich zur Verwendung eines Dotierstoffsalzes mit einem zweiwertigen Anion deutliche Verbesserungen der elektrischen Eigenschaften möglich sind.

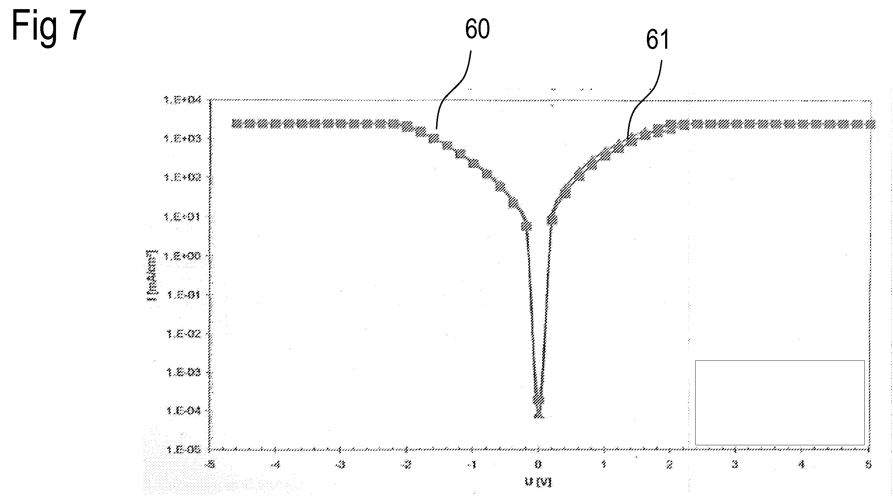

Figur 7 zeigt Stromspannungskennlinien von den bereits im Zusammenhang mit Figur 5 beschriebenen BCP-Proben vor und nach der Belastung mit einem Strom von 1 mA über 66 Stunden. Dabei wurde eine Probe verwendet, die eine mit 15 Vol-% Cäsiumphosphat dotierte BCP-Schicht, die zwischen einer ITO-Anode und einer Aluminiumkathode angeordnet ist, verwendet. Die mit dem Bezugszeichen 61 gekennzeichnete Stromspannungskennlinie zeigt dabei das Stromspannungsverhalten vor der Belastung mit 1 mA und die mit 60 gekennzeichnete Stromspannungskennlinie die I-U-Charakteristik nach der Belastung mit 1 mA über 66 Stunden. Deutlich ist zu erkennen, dass die hohe Strombelastung nicht zu einer merklichen Degradation der BCP-Schicht führt, sodass davon ausgegangen werden kann, dass organische elektronische Vorrichtungen mit dem erfindungsgemäßen elektronentransportierenden Bereich eine hohe Lebensdauer aufweisen.

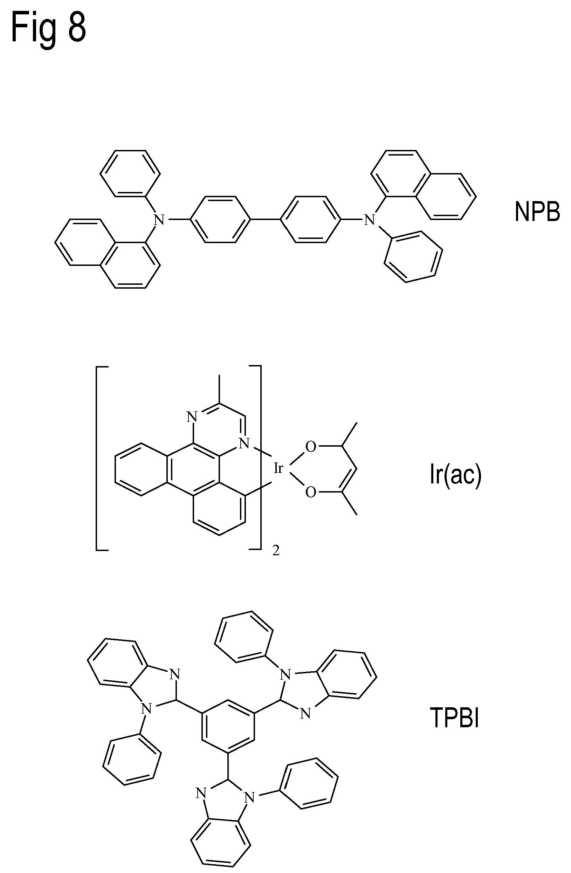

Figur 8 die Struktur von drei organischen Verbindungen wie sie beispielsweise in einer OLED zum Einsatz kommen können. Die erste Strukturformel zeigt NPB (N,N'-Di(naphthyl-1-yl)-N-N'-diphenyl-benzidin) welches beispielsweise als Lochtransportschicht und Matrix für emittierende Stoffe geeignet ist. Die zweite Strukturformel zeigt Ir(ac) (Iridium(III)bis(2-methyldibenzo-[f,h]quinoxalin) (acetylacetonat)). Der Ir-Komplex kann beispielsweise als roter phosphoreszierender Farbstoff in einer OLED verwendet werden. Die dritte Strukturformel zeigt TPBI (1,3,5-Tris(1-phenyl-1H-benzimidazol-2-yl)benzene), die organische Verbindung III. Diese Verbindung kann unter anderem für die löcherblockierende Schicht sowie für die elektronenleitende Schicht 3A, 3B als Matrixmaterial verwendet werden.

Figur 9 zeigt im schematischen Querschnitt eine weitere Ausführungsform einer organischen elektronischen Vorrichtung, die hier als organischer Feldeffekttransistor ausgebildet ist. Auf dem Substrat 1 ist dabei die erste Elektrode 2 angeordnet, welche als Gate-Elektrodenschicht ausgeformt ist. Auf die erste Elektrode 2 folgt eine Isolatorschicht 60, welche beispielsweise ein Dielektrikum umfassen kann. Die zweite Elektrode 4 ist als getrennte Source/Drain-Kontaktschicht ausgeformt. Zwischen den getrennten Source/Drain-Kontaktschichten ist ein Halbleiter 80 angeordnet, der ein lochleitendes Material umfasst. Der organische Feldeffekttransistor umfasst des Weiteren eine Deckschicht 70, die beispielsweise zur Verkapselung dienen kann. Die zweite Elektrode 4, die getrennten Source/Drain-Kontaktschichten können dabei auch die erfindungsgemäßen elektronenleitenden Bereiche und Zusammensetzungen umfassen. Insbesondere kann die elektronenleitende Schicht auf der Oberfläche der Elektroden 4 angeordnet sein und die Injektion von Elektronen aus diesen Elektroden 4 begünstigen.

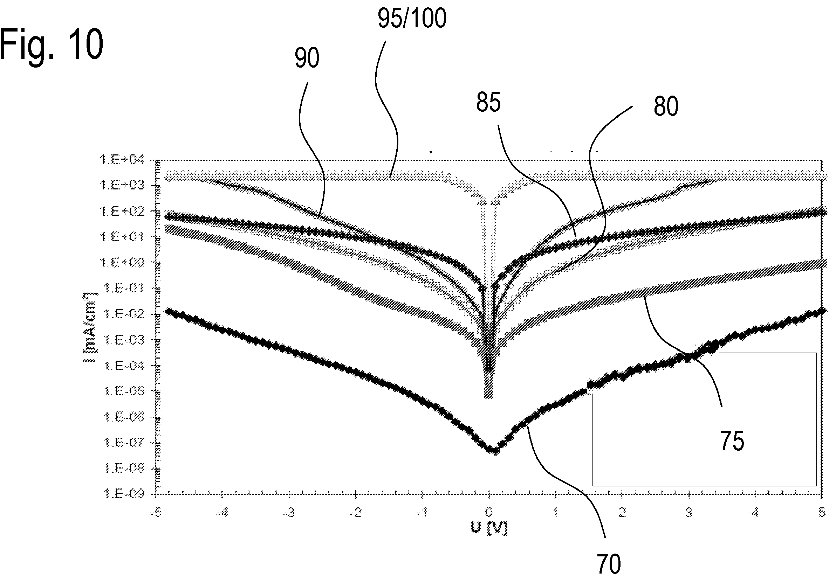

Figur 10 zeigt Stromspannungskennlinien von Vorrichtungen, die vom Aufbau analog sind zu den bereits im Zusammenhang mit Figur 5 beschriebenen Vorrichtungen. In diesem Fall wurden Vorrichtungen hergestellt, in denen verschiedene Matrix-materialien mit dem Cäsium-Salz der Methantetracarbonsäure (Cs₄C₅O₈) dotiert wurden. Wie beim Cäsium-Phosphat auch, wurden hier mittels Ko-Verdampfung 200nm dicke dotierte Schichten auf einer ITO-Schicht abgeschieden und mit einer Aluminium Elektrode kontaktiert. Es wurden dadurch wieder Vorrichtungen mit einer Fläche von 4 mm² erzeugt deren Strom-Spannungskennlinien vermessen wurden. Als Matrix-Materialien wurden BCP, sowie kommerziell erhältliche Materialien ETM-033, LG201 (erhältlich von LG) und ET7 getestet. Die mit 70 gekennzeichnete Stromspannungskennlinie stellt dabei das Stromspannungsverhalten einer reinen BCP-Schicht dar, während die mit 75 bezeichnete Linie eine Dotierung mit 5 Vol-% Cäsium-Methantetracarbonsäure in BCP kennzeichnet. Die mit 80 bezeichnete Stromspannungskennlinie wurde gemessen, wenn eine Dotierung mit 15 Vol-% Cäsium-Methantetracarbonsäure in BCP vorliegt und die Stromspannungskennlinie 85 wurde bei einer Dotierung des Matrixmaterials ETM-033 mit 5 Vol-% Cäsium-Methantetracarbonsäure erhalten. Bei einer Dotierung des Matrixmaterials ETM-033 mit 15 Vol-% Cäsium-Methantetracarbonsäure wurde die mit 90 bezeichnete I-U-Charakteristik erhalten. Die beiden sehr ähnlichen Strom-Spannungskennlinien 95 und 100 kennzeichnen die I-U-Charakteristik von LG201 oder einer ET7-Schicht, die jeweils mit 5 Vol-% Cäsium-Methantetracarbonsäure dotiert sind. Die angegebenen Volumen-Konzentrationen sind Annahmen die aufgrund der Verdampfungsraten gemacht wurden. Die tatsächlichen Konzentrationen sind vermutlich geringer, wobei die relative Konzentration bei allen Materix-Materialien identisch und damit vergleichbar ist. Auch entspricht die erhöhte Konzentration sicher dem Faktor 3. Es ist daher aber auch möglich, dass die tatsächlichen Konzentrationen z.B. bei 3% und 9% liegen. Die waagerechten Bereiche der Kennlinien für ET7 und LG201 stellen keine Strombegrenzung durch die Vorrichtung dar, sondern stellen die Stromgrenze des Messgerätes dar.

Deutlich ist zu erkennen, dass auch durch die Dotierung mit Cäsium-Methantetracarbonsäure deutliche Verbesserungen des elektrischen Verhaltens der elektronenleitenden Schichten zu beobachten sind. Synthese der Casium-Salze der Methantetracarbonsäure und der Methantricarbonsäure:
Unter inerten Bedingungen wird 1Mol Malonsäurediethylester in 1Mol frisch bereitete Natriumethanolatlösung getropft. Danach tropft man 1 mol Chlorameisensäureethylester zu und erwärmt eine 1h bei 50°C. Die Reaktionsmischung wird nun erneut mit 1mol frisch bereiteter Natriumethanolatlösung versetzt, gefolgt von 1Mol Chlorameisensäureethylester. Abschließend wird nochmals 1h bei 50°C und 1h am Rückfluß erwärmt. Das Reaktionsgemisch wird mit Eisessig schwach angesäuert und bis zu einem Öl am Rotationsverdampfer eingeengt. Nun wird der Rückstand mit Wasser versetzt und der Tetracarbonsäureester mittels Ether extrahiert. Die getrocknete Etherphase wird am Rotationsverdampfer vollständig vom Ether befreit und das zurückbleibende Öl im Vakuum fraktioniert Kp: 170°C / 12mbar. Die Methantetacarbonsäuretetraethylester-fraktion wird mit der äquivalenten Menge Cäsiumhydroxid in Wasser gerührt bis die zweiphasige Mischung ineinander gelöst ist. Das Lösemittel Wasser wird am Rotationsverdampfer komplett abdestilliert und der Rückstand aus Methanol umkristallisiert. Das kristallisierende weiße Produkt wird abgesaugt und nach dem Trocknen im Vakuum in einem Drainsublimator im Argonstrom Vakuum (10-2 mbar) bei 300°C getrocknet. Das getrocknete Cäsiumsalz der Methantetracarbonsäure wird in einer Glovebox geerntet ohne vorher der Luft auszusetzen (gräulich-weißes Pulver mit einer Sublimationstemperatur >625°C).

Analog dazu kann auch das Cäsiumsalz der Methantricarbonsäure hergestellt werden, wobei die Synthese allerdings bei der ersten Alkylierungstufe abgebrochen wird.

## Patentansprüche

1. Organische, elektronische Vorrichtung mit
- einem Substrat (1),
- einer ersten Elektrode (2),
- einer zweiten Elektrode (4), und
- einem zwischen der ersten und zweiten Elektrode angeordneten elektronenleitenden Bereich (3A, 3B), der
- ein organisches Matrixmaterial (3B), und ein Salz (3A) aufweist,
- wobei das organische Matrixmaterial (3B) ausgewählt ist aus
o Materialien der Wiederholeinheit mit folgender allgemeiner Formel: 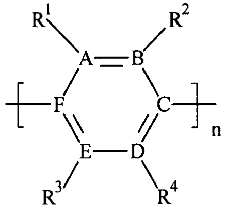 hierbei
▪ stehen die Ringglieder A bis F unabhängig voneinander für C oder N mit der Maßgabe dass maximal zwei N-Atome vorhanden sein können,
▪ n ist eine ganze Zahl zwischen 2 bis 8, wobei die freien Valenzen der Enden der Ketten der Wiederholeinheiten jeweils unabhängig voneinander durch H, Methyl, Phenyl, 2-Pyridyl, 3-Pyridyl bzw. 4-Pyridyl abgesättigt sein können,
▪ R¹ bis R⁴ können jeweils unabhängig voneinander H, Methyl, Phenyl, 2-Pyridyl, 3-Pyridyl bzw. 4-Pyridyl sein und / oder R¹ und R² bzw R³ und R⁴ können miteinander Butadien bzw. Azabutadieneinheiten bilden, so dass ein anneliertes 6-Ring System gebildet wird und die Wiederholeinheiten können zwischen dem n-ten und (n+1)-ten Ring durch Ethylen- bzw. Azomethineinheiten verbunden sein, wobei Phenanthren- bzw. Azaphenanthreneinheiten gebildet werden.
∘ oder aus den folgenden Verbindungen:
▪ 2,2',2''-(1,3,5-Benzintriyl)-tris(1-phenyl-1-H-benzimidazol),
▪ 2-(4-Biphenylyl)-5-(4-tert.-butylphenyl)-1,3,4-oxadiazol,
▪ 2,9-Dimethyl-4,7-diphenyl-1,10-phenanthrolin (BCP),
▪ 4-(Naphthalen-1-yl)-3,5diphenyl-4H-1,2,4-triazol,
▪ 1,3-Bis[2-(2,2'-bipyridin-6-yl)-1,3,4-oxadiazo-5-yl]benzol,
▪ 4,7-Diphenyl-1,10-phenanthrolin,
▪ 3-(4-Biphenylyl)-4-phenyl-5-tert-butylphenyl-1,2,4-triazol,
▪ 6,6'-Bis[5-biphenyl-4-yl)-1,3,4-oxadiazo-2-yl]2,2'bipyridyl,
▪ 2-phenyl-9,10-di(naphthalen-2-yl)-anthracen,
▪ 2,7-Bis[2-(2,2'-bipyridin-6-yl)1,3,4oxadiazo-5-yl]-9,9-dimethylfluoren,
▪ 1,3-Bis[2-(4-tert.-butylphenyl)-1,3,4-oxadiazo-5-yl)benzol,
▪ 2-(naphthalen-2-yl)-4,7-diphenyl-1,10-phenanthrolin,
▪ 2,9-Bis(naphthalen-2-yl)-4,7-diphenyl-1,10-phenanthrolin,
▪ Tris(2,4,6-trimethyl-3-(pyridine-3yl)phenyl)boran,
▪ 1-methyl-2-(4-(naphthalene-2-yl)phenyl)1-H-imidazo[4,5-f][1,10]-phenanthrolin,
▪ Silole mit Silacyclopentadien-Einheiten.
- und wobei das Salz (3A)
o ein Metallkation und
∘ ein Anion umfasst, **dadurch gekennzeichnet, dass** das Anion mit zumindest dreifacher Wertigkeit ausgewählt ist aus: Phosphatanionen PO₄³⁻ und anionischen multivalenten organischen Anionen mit zumindest dreifacher Wertigkeit.

2. Elektronische Vorrichtung nach Anspruch 1,
wobei der elektronenleitende Bereich eine elektronenleitende Schicht aufweist, die das organische Matrixmaterial enthält, in der das Salz als n-Dotierstoff eingebracht ist.

3. Elektronische Vorrichtung nach Anspruch 2,
- wobei der n-Dotierstoff in einer Konzentration von 1 bis 50 Vol%, bevorzugt 5 bis 15 Vol% in dem organischen Matrixmaterial vorliegt.

4. Elektronische Vorrichtung nach einem der vorhergehenden Ansprüche 2 oder 3,
- wobei das Salz über das Metallkation an das organische Matrixmaterial koordiniert ist.

5. Elektronische Vorrichtung nach einem der vorhergehenden Ansprüche 2 bis 4,
- wobei in der elektronenleitenden Schicht eine Koordinationsverbindung zwischen dem Metallkation und dem organischen Matrixmaterial vorliegt, in die das Anion eingelagert ist.

6. Elektronische Vorrichtung nach einem der vorhergehenden Ansprüche,
- wobei das Metallkation ausgewählt ist aus: Alkali-, Erdalkalimetallkationen, Ag⁺, Cu⁺ und Tl⁺ sowie Kombinationen davon.

7. Elektronische Vorrichtung nach einem der vorhergehenden Ansprüche,
- wobei das organische Matrixmaterial eine stickstoffhaltige heterozyklische Verbindung umfasst.

8. Elektronische Vorrichtung nach einem der vorhergehenden Ansprüche,
- wobei das organische Matrixmaterial ausgewählt ist aus: 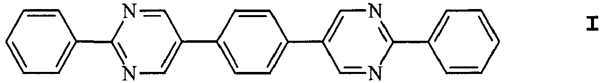 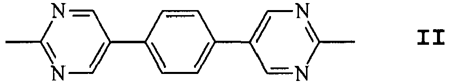 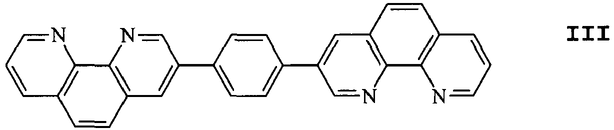 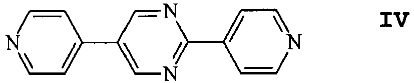 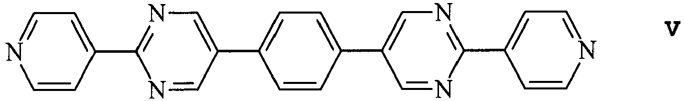 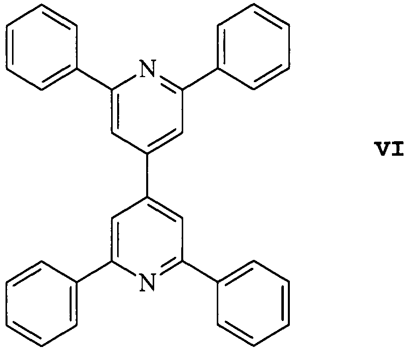 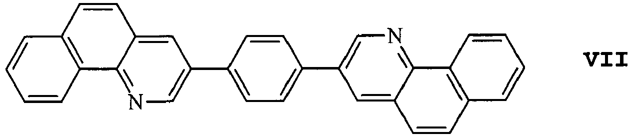 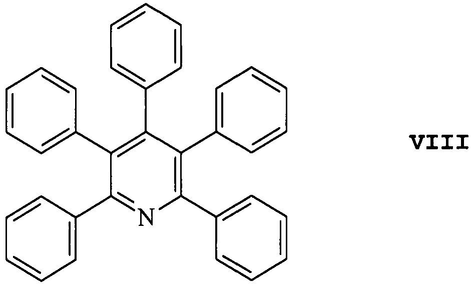 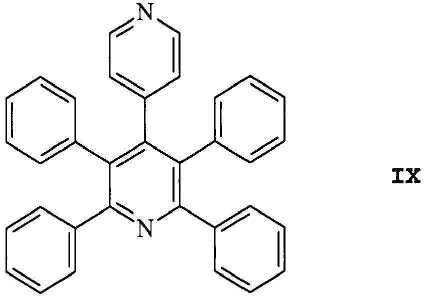 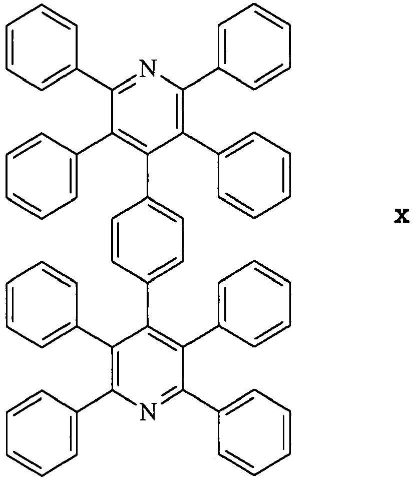 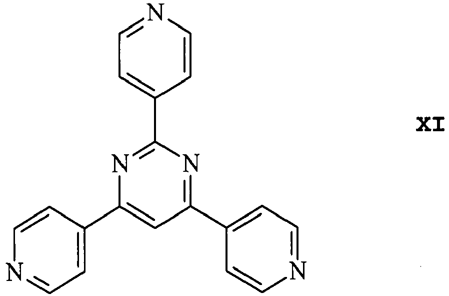 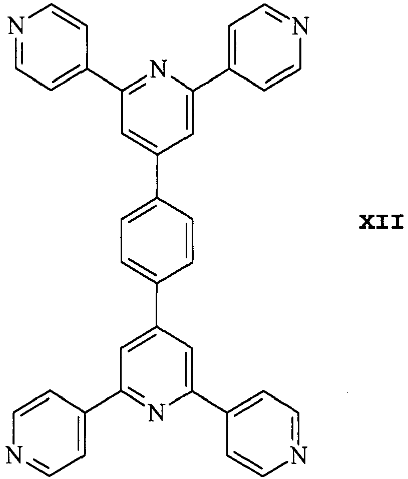 oder Kombinationen davon.

9. Elektronische Vorrichtung nach einem der vorhergehenden Ansprüche, ausgebildet als organische Elektrolumineszenz-Vorrichtung (OLED), weiterhin umfassend
- eine organische elektrolumineszierende Schicht (5) zwischen dem elektronenleitenden Bereich (3A, 3B) und einer der Elektroden (2 oder 4).

10. Elektronische Vorrichtung nach einem der vorhergehenden Ansprüche 1 bis 8, ausgebildet als organische photosensitive Vorrichtung, weiterhin umfassend,
- eine organische photoaktive Schicht (5) zwischen dem elektronenleitenden Bereich (3A, 3B) und einer der Elektroden (2 oder 4).

11. Verfahren zur Herstellung einer organischen elektronischen Vorrichtung, gemäß Anspruch 1, mit den Verfahrensschritten:
A) Bereitstellen eines Substrates (1) mit einer, ersten Elektrode (2),
B) Aufbringen eines elektronenleitenden Bereichs (3A, 3B) auf der ersten Elektrode (2),
C) Aufbringen einer zweiten Elektrode (4), die in elektrisch leitendem Kontakt mit dem elektronenleitenden Bereich (3A, 3B) steht,
- wobei das Aufbringen des elektronenleitenden Bereichs (3A, 3B) durch Verdampfen des organischen Matrixmaterials und des Salzes erfolgt.

12. Verfahren zur Herstellung einer organischen elektronischen Vorrichtung nach dem vorhergehenden Anspruch, wobei das Aufbringen des elektronenleitenden Bereichs (3A, 3B) durch Ko-Verdampfung eines Salzes des Anions und des Metallkations mit dem organischen Matrixmaterial erfolgt.

13. Elektronenleitende Zusammensetzung, umfassend:
- ein elektronenleitendes Matrixmaterial, wobei das Matrixmaterial ausgewählt ist aus
o Materialien der Wiederholeinheit mit folgender allgemeiner Formel: 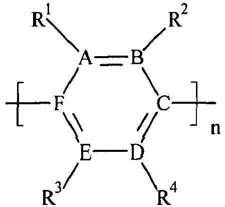 hierbei
▪ stehen die Ringglieder A bis F unabhängig voneinander für C oder N mit der Maßgabe dass maximal zwei N-Atome vorhanden sein können,
▪ n ist eine ganze Zahl zwischen 2 bis 8, wobei die freien Valenzen der Enden der Ketten der Wiederholeinheiten jeweils unabhängig voneinander durch H, Methyl, Phenyl, 2-Pyridyl, 3-Pyridyl bzw. 4-Pyridyl abgesättigt sein können,
▪ R¹ bis R⁴ können jeweils unabhängig voneinander H, Methyl, Phenyl, 2-Pyridyl, 3-Pyridyl bzw. 4-Pyridyl sein und / oder R¹ und R² bzw R³ und R⁴ können miteinander Butadien bzw. Azabutadieneinheiten bilden, so dass ein anneliertes 6-Ring System gebildet wird und die Wiederholeinheiten können zwischen dem n-ten und (n+1)-ten Ring durch Ethylen- bzw. Azomethineinheiten verbunden sein, wobei Phenanthren- bzw. Azaphenanthreneinheiten gebildet werden.
∘ oder aus den folgenden Verbindungen:
▪ 2,2',2''-(1,3,5-Benzintriyl)-tris(1-phenyl-1-H-benzimidazol),
▪ 2-(4-Biphenylyl)-5-(4-tert.-butylphenyl)-1,3,4-oxadiazol,
▪ 2,9-Dimethyl-4,7-diphenyl-1,10-phenanthrolin (BCP),
▪ 4-(Naphthalen-1-yl)-3,5diphenyl-4H-1,2,4-triazol,
▪ 1,3-Bis[2-(2,2'-bipyridin-6-yl)-1,3,4-oxadiazo-5-yl]benzol,
▪ 4,7-Diphenyl-1,10-phenanthrolin,
▪ 3-(4-Biphenylyl)-4-phenyl-5-tert-butylphenyl-1,2,4-triazol,
▪ 6,6'-Bis[5-biphenyl-4-yl)-1,3,4-oxadiazo-2-yl]2,2'bipyridyl,
▪ 2-phenyl-9,10-di(naphthalen-2-yl)-anthracen,
▪ 2,7-Bis[2-(2,2'-bipyridin-6-yl)1,3,4oxadiazo-5-yl]-9,9-dimethylfluoren,
▪ 1,3-Bis[2-(4-tert.-butylphenyl)-1,3,4-oxadiazo-5-yl)benzol,
▪ 2-(naphthalen-2-yl)-4,7-diphenyl-1,10-phenanthrolin,
▪ 2,9-Bis(naphthalen-2-yl)-4,7-diphenyl-1,10-phenanthrolin,
▪ Tris(2,4,6-trimethyl-3-(pyridine-3yl)phenyl)boran,
▪ 1-methyl-2-(4-(naphthalene-2-yl)phenyl)1-H-imidazo[4,5-f][1,10]-phenanthrolin,
▪ Silole mit Silacyclopentadien-Einheiten
und
- ein Salz als n-Dotierstoff, wobei das Salz ein Anion und ein Kation aufweist, **dadurch gekennzeichnet, dass** das Anion mit zumindest dreifacher Wertigkeit ausgewählt ist aus: Phosphatanionen PO₄³⁻ und anionischen multivalenten organischen Anionen mit zumindest dreifacher Wertigkeit.

## Claims

1. Organic electronic device comprising
- a substrate (1),
- a first electrode (2),
- a second electrode (4), and
- an electron-conducting region (3A, 3B) which is arranged between the first and second electrode and comprises
- an organic matrix material (3B) and a salt (3A),
- wherein the organic matrix material (3B) is selected from
- materials of the repeat unit with the following general formula: 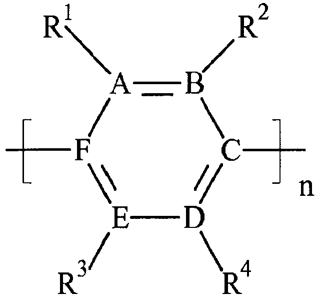 where
- the ring members A to F are each independently C or N, with the proviso that a maximum of two nitrogen atoms may be present,
- n is an integer from 2 to 8, where the free valences of the ends of the chains of the repeat units may each independently be satisfied by H, methyl, phenyl, 2-pyridyl, 3-pyridyl or 4-pyridyl,
- R¹ to R⁴ may each independently be H, methyl, phenyl, 2-pyridyl, 3-pyridyl or 4-pyridyl, and/or R¹ and R² or R³ and R⁴ may together form butadiene or azabutadiene units, such that a fused 6-membered ring system is formed and the repeat units may be bonded by ethylene or azomethine units between the nth and (n+1)th ring to form phenanthrene or azaphenanthrene units,
- or from the following compounds:
- 2,2',2''-(1,3,5-benzenetriyl)tris(1-phenyl-1H-benzimidazole),
- 2-(4-biphenylyl)-5-(4-tert-butylphenyl)-1,3,4-oxadiazole,
- 2,9-dimethyl-4,7-diphenyl-1,10-phenanthroline (BCP),
- 4-(naphthalen-1-yl)-3,5-diphenyl-4H-1,2,4-triazole,
- 1,3-bis[2-(2,2'-bipyridin-6-yl)-1,3,4-oxadiazo-5-yl]benzene,
- 4,7-diphenyl-1,10-phenanthroline,
- 3-(4-biphenylyl)-4-phenyl-5-tert-butylphenyl-1,2,4-triazole,
- 6,6'-bis[5-biphenyl-4-yl)-1,3,4-oxadiazo-2-yl]-2,2'-bipyridyl,
- 2-phenyl-9,10-di(naphthalen-2-yl)anthracene,
- 2,7-bis[2-(2,2'-bipyridin-6-yl)-1,3,4-oxadiazo-5-yl]-9,9-dimethylfluorene,
- 1,3-bis[2-(4-tert-butylphenyl)-1,3,4-oxadiazo-5-yl)benzene,
- 2-(naphthalen-2-yl)-4,7-diphenyl-1,10-phenanthroline,
- 2,9-bis(naphthalen-2-yl)-4,7-diphenyl-1,10-phenanthroline,
- tris(2,4,6-trimethyl-3-(pyridin-3-yl)phenyl)borane,
- 1-methyl-2-(4-(naphthalen-2-yl)phenyl)-1H-imidazo[4,5-f][1,10]-phenanthroline,
- siloles with silacyclopentadiene units,
- and wherein the salt (3A) comprises
- a metal cation and
- an anion, **characterized in that** the anion of at least threefold negative valence is selected from: phosphate anions PO₄³⁻ and anionic multivalent organic anions of at least threefold negative valence.

2. Electronic device according to Claim 1,
wherein the electron-conducting region comprises an electron-conducting layer which comprises the organic matrix material in which the salt has been introduced as an n-dopant.

3. Electronic device according to Claim 2,
- wherein the n-dopant is present in the organic matrix material in a concentration of 1 to 50% by volume, preferably 5 to 15% by volume.

4. Electronic device according to either of the preceding Claims 2 and 3,
- wherein the salt is coordinated to the organic matrix material via the metal cation.

5. Electronic device according to any of the preceding Claims 2 to 4,
- wherein a coordination compound between the metal cation and the organic matrix material is present in the electron-conducting layer, into which compound the anion has been intercalated.

6. Electronic device according to any of the preceding claims,
- wherein the metal cation is selected from: alkali metal cations, alkaline earth metal cations, Ag⁺, Cu⁺ and Tl⁺, and combinations thereof.

7. Electronic device according to any of the preceding claims,
- wherein the organic matrix material comprises a heterocyclic nitrogen compound.

8. Electronic device according to any of the preceding claims,
- wherein the organic matrix material is selected from: 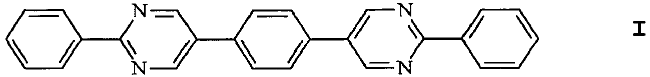 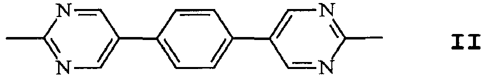 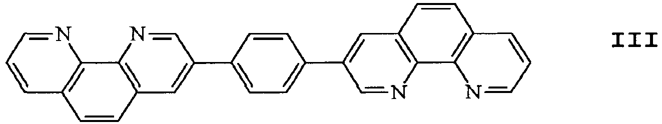 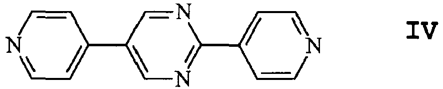 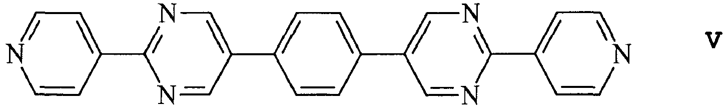 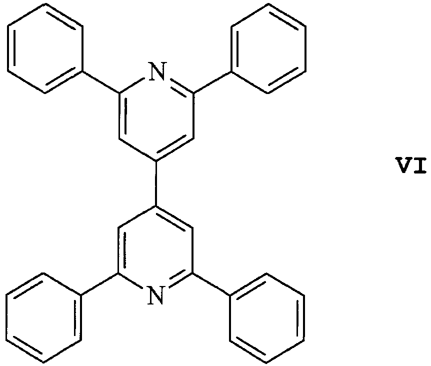 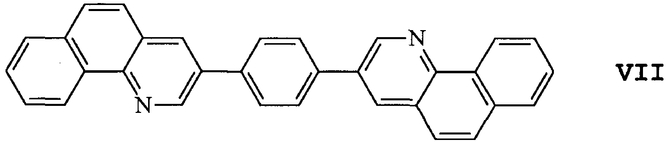 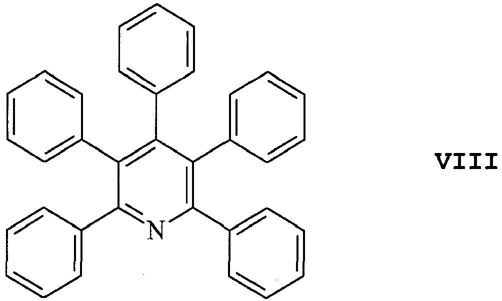 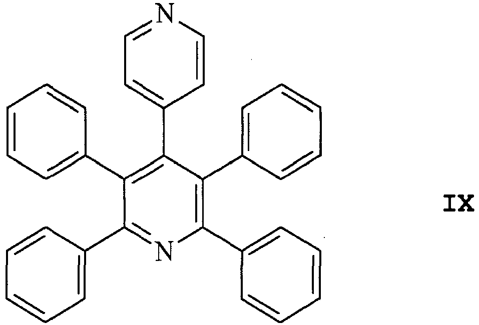 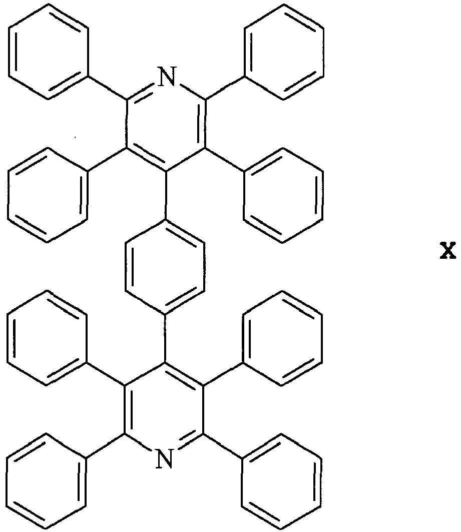 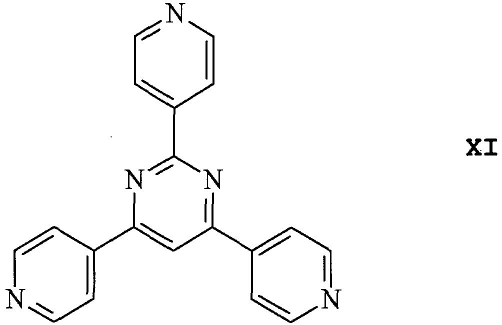 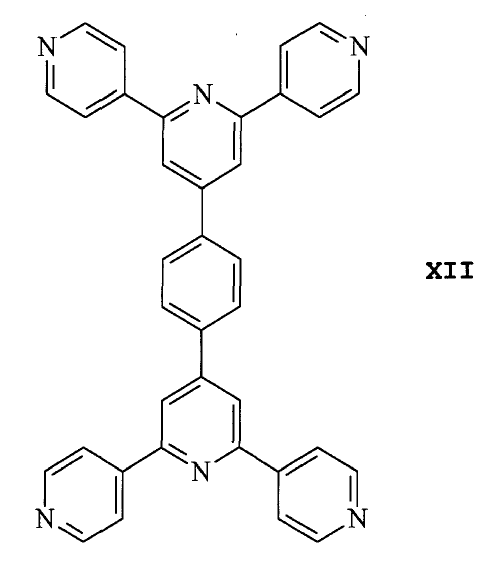 or combinations thereof.

9. Electronic device according to any of the preceding claims, in the form of an organic electroluminescent device (OLED), further comprising
- an organic electroluminescent layer (5) between the electron-conducting region (3A, 3B) and one of the electrodes (2 or 4).

10. Electronic device according to any of the preceding Claims 1 to 8, in the form of an organic photosensitive device, further comprising
- an organic photoactive layer (5) between the electron-conducting region (3A, 3B) and one of the electrodes (2 or 4).

11. Process for producing an organic electronic device according to Claim 1, comprising the process steps of:
A) providing a substrate (1) with a first electrode (2),
B) applying an electron-conducting region (3A, 3B) to the first electrode (2),
C) applying a second electrode (4) in electrically conductive contact with the electron-conducting region (3A, 3B),
- wherein the electron-conducting region (3A, 3B) is applied by vaporizing the organic matrix material and the salt.

12. Process for producing an organic electronic device according to the preceding claim,
- wherein the electron-conducting region (3A, 3B) is applied by covaporization of a salt of the anion and of the metal cation with the organic matrix material.

13. Electron-conducting composition comprising:
- an electron-conducting matrix material,
and
wherein the matrix material is selected from
- materials of the repeat unit with the following general formula: 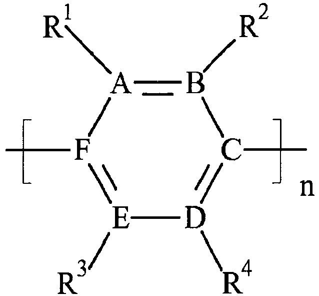 where
- the ring members A to F are each independently C or N, with the proviso that a maximum of two nitrogen atoms may be present,
- n is an integer from 2 to 8, where the free valences of the ends of the chains of the repeat units may each independently be satisfied by H, methyl, phenyl, 2-pyridyl, 3-pyridyl or 4-pyridyl,
- R¹ to R⁴ may each independently be H, methyl, phenyl, 2-pyridyl, 3-pyridyl or 4-pyridyl, and/or R¹ and R² or R³ and R⁴ may together form butadiene or azabutadiene units, such that a fused 6-membered ring system is formed and the repeat units may be bonded by ethylene or azomethine units between the nth and (n+1)th ring to form phenanthrene or azaphenanthrene units,
- or from the following compounds:
- 2,2',2''-(1,3,5-benzenetriyl)tris(1-phenyl-1H-benzimidazole),
- 2-(4-biphenylyl)-5-(4-tert-butylphenyl)-1,3,4-oxadiazole,
- 2,9-dimethyl-4,7-diphenyl-1,10-phenanthroline (BCP),
- 4-(naphthalen-1-yl)-3,5-diphenyl-4H-1,2,4-triazole,
- 1,3-bis[2-(2,2'-bipyridin-6-yl)-1,3,4-oxadiazo-5-yl]benzene,
- 4,7-diphenyl-1,10-phenanthroline,
- 3-(4-biphenylyl)-4-phenyl-5-tert-butylphenyl-1,2,4-triazole,
- 6,6'-bis[5-biphenyl-4-yl)-1,3,4-oxadiazo-2-yl]-2,2'-bipyridyl,
- 2-phenyl-9,10-di(naphthalen-2-yl)anthracene,
- 2,7-bis[2-(2,2'-bipyridin-6-yl)-1,3,4-oxadiazo-5-yl]-9,9-dimethylfluorene,
- 1,3-bis[2-(4-tert-butylphenyl)-1,3,4-oxadiazo-5-yl)benzene,
- 2-(naphthalen-2-yl)-4,7-diphenyl-1,10-phenanthroline,
- 2,9-bis(naphthalen-2-yl)-4,7-diphenyl-1,10-phenanthroline,
- tris(2,4,6-trimethyl-3-(pyridin-3-yl)phenyl)borane,
- 1-methyl-2-(4-(naphthalen-2-yl)phenyl)-1H-imidazo[4,5-f][1,10]-phenanthroline,
- siloles with silacyclopentadiene units,
and wherein the salt (3A) comprises
- a salt as an n-dopant, said salt comprising
- an anion and a cation, **characterized in that** the anion of at least threefold negative valence is selected from:
phosphate anions PO₄³⁻ and anionic multivalent organic anions of at least threefold negative valence.

## Revendications

1. Dispositif électronique, organique présentant
- un substrat (1),
- une première électrode (2),
- une deuxième électrode (4) et
- une zone (3A, 3B) conduisant les électrons disposée entre la première et la deuxième électrode, qui présente
- un matériau de matrice organique (3B) et un sel (3A),
- le matériau de matrice organique (3B) étant choisi parmi
- les matériaux de l'unité récurrente présentant la formule générale suivante: 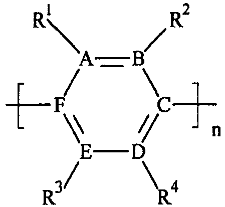 dans laquelle
- les chaînons de cycle A à F représentent, indépendamment les uns des autres, C ou N, à condition qu'au maximum deux atomes de N puissent être présents,
- n vaut un nombre entier de 2 à 8, les valences libres des extrémités des chaînes des unités récurrentes pouvant à chaque fois être saturées, indépendamment les unes des autres, par H, méthyle, phényle, 2-pyridyle, 3-pyridyle ou 4-pyridyle,
- R¹ à R⁴ peuvent représenter à chaque fois, indépendamment les uns des autres, H, méthyle, phényle, 2-pyridyle, 3-pyridyle ou 4-pyridyle et/ou R¹ et R² ou R³ et R⁴ peuvent former, l'un avec l'autre, butadiène ou des unités azabutadiène, de manière telle qu'un système annelé à 6 cycles est formé et les unités récurrentes peuvent être liées entre le nième et le (n+1)ième cycle par des unités éthylène ou azométhine, des unités phénanthrène ou azaphénanthrène étant formées,
- ou parmi les composés suivants:
- 2,2',2"-(1,3,5-benzènetriyl)-tris(1-phényl-1-H-benzimidazole),
- 2-(4-biphénylyl)-5-(4-tert-butylphényl)-1,3,4-oxadiazole,
- 2,9-diméthyl-4,7-diphényl-1,10-phénanthroline (BCP),
- 4-(naphtalén-1-yl)-3,5-diphényl-4H-1,2,4-triazole,
- 1,3-bis[2-(2,2'-bipyridin-6-yl)-1,3,4-oxadiazo-5-yl]benzène,
- 4,7-diphényl-1,10-phénanthroline,
- 3-(4-biphénylyl)-4-phényl-5-tert-butylphényl-1,2,4-triazole,
- 6,6'-bis[5-biphényl-4-yl)-1,3,4-oxadiazo-2-yl]2,2'bipyridyle,
- 2-phényl-9,10-di(naphtalén-2-yl)-anthracène,
- 2,7-bis[2-(2,2'-bipyridin-6-yl)-1,3,4-oxadiazo-5-yl]-9,9-diméthylfluorène,
- 1,3-bis[2-(4-tert-butylphényl)-1,3,4-oxadiazo-5-yl)benzène,
- 2-(naphtalén-2-yl)-4,7-diphényl-1,10-phénanthroline,
- 2,9-bis(naphtalén-2-yl)-4,7-diphényl-1,10-phénanthroline,
- tris(2,4,6-triméthyl-3-(pyridin-3-yl)phényl)borane,
- 1-méthyl-2-(4-(naphtalén-2-yl)phényl)1-H-imidazo[4,5-f][1,10]-phénanthroline,
- silols avec des unités silacyclopentadiène,
- et le sel (3A) comprenant
- un cation métallique et
- un anion, **caractérisé en ce que** l'anion au moins trivalent est choisi parmi:
- les anions phosphate PO₄³⁻ et
- les anions organiques multivalents anioniques au moins trivalents.

2. Dispositif électronique selon la revendication 1, la zone conduisant les électrons présentant une couche conduisant les électrons, qui contient le matériau de matrice organique, dans lequel le sel a été introduit comme substance de dopage n.

3. Dispositif électronique selon la revendication 2,
- la substance de dopage n se trouvant à une concentration de 1 à 50% en volume, de préférence de 5 à 15% en volume dans le matériau de matrice organique.

4. Dispositif électronique selon l'une quelconque des revendications précédentes 2 ou 3,
- le sel étant coordiné via le cation métallique au matériau de matrice organique.

5. Dispositif électronique selon l'une quelconque des revendications précédentes 2 à 4,
- un composé de coordination, dans lequel l'anion est intégré, se trouvant dans la couche conduisant les électrons entre le cation métallique et le matériau de matrice organique.

6. Dispositif électronique selon l'une quelconque des revendications précédentes,
- le cation métallique étant choisi parmi: les cations de métal alcalin, les cations de métal alcalino-terreux, Ag⁺, Cu⁺ et Tl⁺ ainsi que leurs combinaisons.

7. Dispositif électronique selon l'une quelconque des revendications précédentes,
- le matériau de matrice organique comprenant un composé hétérocyclique contenant de l'azote.

8. Dispositif électronique selon l'une quelconque des revendications précédentes,
- le matériau de matrice organique étant choisi parmi 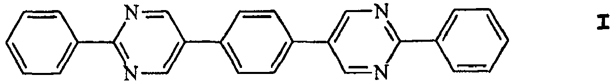 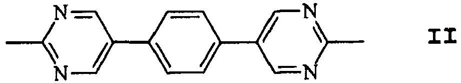 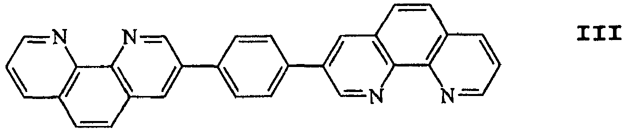 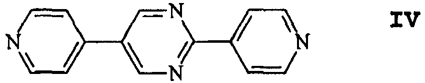 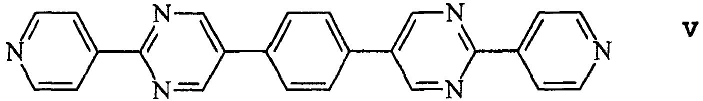 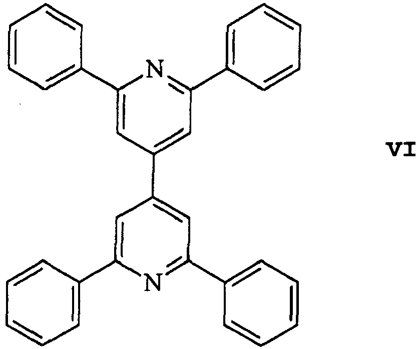 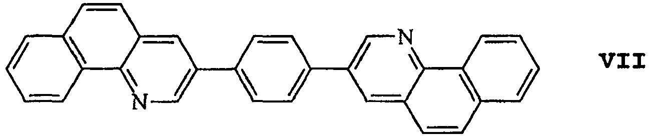 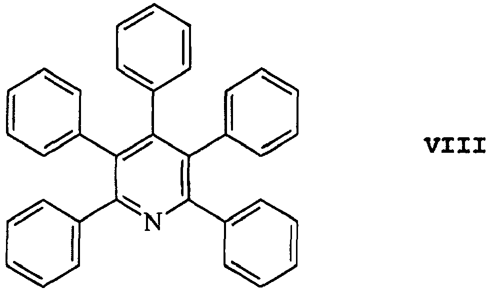 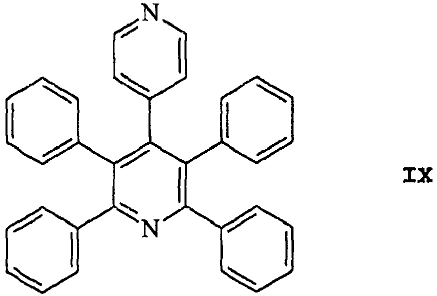 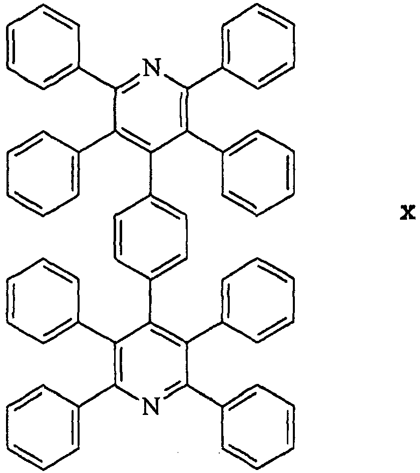 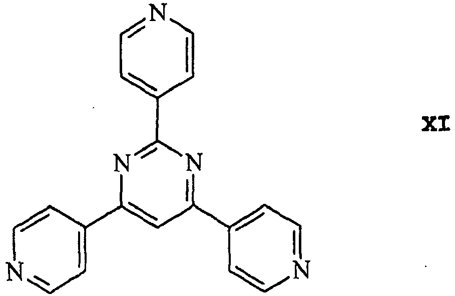 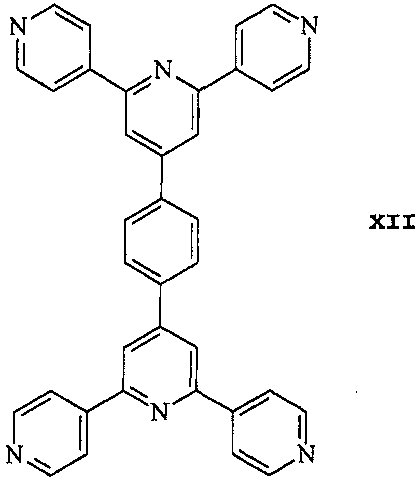 ou leurs combinaisons.

9. Dispositif électronique selon l'une quelconque des revendications précédentes, réalisé sous forme de dispositif électroluminescent organique (DELO), comprenant en outre
- une couche (5) électroluminescente organique entre la zone (3A, 3B) conduisant les électrons et une des électrodes (2 ou 4).

10. Dispositif électronique selon l'une quelconque des revendications précédentes 1 à 8, réalisé sous forme de dispositif photosensible organique, comprenant en outre
- une couche (5) photoactive organique entre la zone (3A, 3B) conduisant les électrons et une des électrodes (2 ou 4).

11. Procédé pour la fabrication d'un dispositif électronique organique, selon la revendication 1, présentant les étapes de procédé consistant à:
A) prendre un substrat (1) présentant une première électrode (2),
B) appliquer une zone (3A, 3B) conduisant les électrons sur la première électrode (2),
C) applique une deuxième électrode (4), qui est en contact électriquement conducteur avec la zone (3A, 3B) conduisant les électrons,
- l'application de la zone (3A, 3B) conduisant les électrons ayant lieu par évaporation du matériau de matrice organique et du sel.

12. Procédé pour la fabrication d'un dispositif électronique organique selon la revendication précédente, l'application de la zone (3A, 3B) conduisant les électrons ayant lieu par co-évaporation d'un sel de l'anion et du cation métallique avec le matériau de matrice organique.

13. Composition conduisant les électrons, comprenant:
- un matériau de matrice conduisant les électrons,
le matériau de matrice étant choisi parmi
- les matériaux de l'unité récurrente présentant la formule générale suivante: 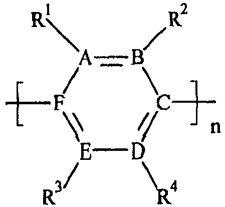 dans laquelle
- les chaînons de cycle A à F représentent, indépendamment les uns des autres, C ou N, à condition qu'au maximum deux atomes de N puissent être présents,
- n vaut un nombre entier de 2 à 8, les valences libres des extrémités des chaînes des unités récurrentes pouvant à chaque fois être saturées, indépendamment les unes des autres, par H, méthyle, phényle, 2-pyridyle, 3-pyridyle ou 4-pyridyle,
- R¹ à R⁴ peuvent représenter à chaque fois, indépendamment les uns des autres, H, méthyle, phényle, 2-pyridyle, 3-pyridyle ou 4-pyridyle et/ou R¹ et R² ou R³ et R⁴ peuvent former, l'un avec l'autre, butadiène ou des unités azabutadiène, de manière telle qu'un système annelé à 6 cycles est formé et les unités récurrentes peuvent être liées entre le nième et le (n+1)ième cycle par des unités éthylène ou azométhine, des unités phénanthrène ou azaphénanthrène étant formées,
- ou parmi les composés suivants:
- 2,2',2"-(1,3,5-benzènetriyl)-tris(1-phényl-1-H-benzimidazole),
- 2-(4-biphénylyl)-5-(4-tert-butylphényl)-1,3,4-oxadiazole,
- 2,9-diméthyl-4,7-diphényl-1,10-phénanthroline (BCP),
- 4-(naphtalén-1-yl)-3,5-diphényl-4H-1,2,4-triazole,
- 1,3-bis[2-(2,2'-bipyridin-6-yl)-1,3,4-oxadiazo-5-yl]benzène,
- 4,7-diphényl-1,10-phénanthroline,
- 3-(4-biphénylyl)-4-phényl-5-tert-butylphényl-1,2,4-triazole,
- 6,6'-bis[5-biphényl-4-yl)-1,3,4-oxadiazo-2-yl]2,2'bipyridyle,
- 2-phényl-9,10-di(naphtalén-2-yl)-anthracène,
- 2,7-bis[2-(2,2'-bipyridin-6-yl)-1,3,4-oxadiazo-5-yl]-9,9-diméthylfluorène,
- 1,3-bis[2-(4-tert-butylphényl)-1,3,4-oxadiazo-5-yl)benzène,
- 2-(naphtalén-2-yl)-4,7-diphényl-1,10-phénanthroline,
- 2,9-bis(naphtalén-2-yl)-4,7-diphényl-1,10-phénanthroline,
- tris(2,4,6-triméthyl-3-(pyridin-3-yl)phényl)borane,
- 1-méthyl-2-(4-(naphtalén-2-yl)phényl)1-H-imidazo[4,5-f][1,10]-phénanthroline,
- silols avec des unités silacyclopentadiène et
- un sel comme substance de dopage n, le sel présentant un anion et un cation, **caractérisée**
**en ce que** l'anion au moins trivalent est choisi parmi: les anions phosphate PO₄³⁻ et
les anions organiques multivalents anioniques au moins trivalents.
